# EUROPÄISCHE PATENTSCHRIFT

(11) **EP 1 618 398 B1**
(45) Veröffentlichungstag und Bekanntmachung des Hinweises auf die Patenterteilung: **21.05.2008**
(21) Anmeldenummer: 04721115.6
(22) Anmeldetag: 17.03.2004
(51) Int. Cl.: G01R 31/36, B60K 6/00, F02N 11/08

(54) **VERFAHREN UND VORRICHTUNG ZUR VORHERSAGE DER STARTF HIGKEIT EINES FAHRZEUGS**
METHOD AND DEVICE FOR PREDICTING THE STARTING CAPACITY OF A VEHICLE
PROCEDE ET SYSTEME PERMETTANT DE PREVOIR LA CAPACITE DE DEMARRAGE D'UN VEHICULE

(30) Priorität: 16.04.2003 DE 10317524
(43) Veröffentlichungstag der Anmeldung: 25.01.2006
(73) Patentinhaber: ROBERT BOSCH GMBH, 70442 Stuttgart (DE)
(72) Erfinder: SCHILLER, Karsten, 70825 Korntal-Muenchingen (DE); BUCHHOLZ, Frank, 71735 Hochdorf (DE)
(86) Internationale Anmeldenummer: PCT/DE2004/000535
(87) Internationale Veröffentlichungsnummer: WO 2004/092758

(56) Entgegenhaltungen:
- EP-A- 0 714 033
- DE-A- 19 705 634
- US-A- 5 565 759
- US-B1- 6 300 763
- US-B1- 6 424 157

## Beschreibung

Die Erfindung betrifft eine Vorrichtung zur Vorhersage der Startfähigkeit eines Fahrzeugs gemäß dem Oberbegriff des Patentanspruchs 1, sowie ein entsprechendes Verfahren gemäß dem Oberbegriff des Patentanspruchs 11.

Fahrzeuge haben aufgrund der zunehmenden Anzahl von Ruheverbrauchern, wie z.B. IR-Empfänger der Zentralverriegelung, Diebstahlsicherung, Sensorik, etc. auch im abgestellten Zustand einen nicht unerheblichen Leistungsverbrauch. Es besteht daher die Gefahr, dass ein abgestelltes Fahrzeug nach längerer Standzeit nicht mehr gestartet werden kann. Zur Information des Fahrers werden daher Einrichtungen eingesetzt, die die Startfähigkeit anzeigen.

Eine Vorrichtung zur Vorhersage der Startfähigkeit eines Fahrzeugs liefert eine Aussage darüber, wie lange ein Fahrzeug abgestellt werden kann, bis die Fahrzeugbatterie soweit entladen ist, dass es gerade noch neu gestartet werden kann, oder darüber, ob ein Start nach einer vorgegebenen Zeitdauer noch möglich sein wird oder nicht. Die Startfähigkeit eines Fahrzeugs wird üblicherweise angenommen, wenn die Batterie in der Lage ist, eine vorgegebene elektrische Startenergie zur Verfügung zu stellen, ohne eine festgelegte Minimal-Klemmenspannung zu unterschreiten, (siehe z.B. US 6,424,157)

Aus der DE-19705634C2 ist es beispielsweise bekannt, die Startfähigkeit eines Fahrzeugs bei vorgegebenem Startstrom und gegebener Starttemperatur durch Berechnung der Klemmenspannung der Batterie bei einem Startvorgang zu bestimmen. Die Klemmenspannung wird dabei aus der Leerlaufspannung und dem Innenwiderstand der Starterbatterie berechnet. Der Startstrom wird während des Startvorgangs gemessen. Eine Vorhersage über eine zukünftige Startfähigkeit eines Fahrzeugs ist dabei nicht möglich. Darüber hinaus ist es relativ aufwendig, den Startstrom der Batterie bei einem Startvorgang zu messen.

Aus der DE-1056970A1 ist ein Verfahren zur Bestimmung der Startfähigkeit eines Fahrzeugs bekannt, bei dem ein mittlerer Spannungsabfall in der Batterie während einer Startphase berechnet und ermittelt wird, ob eine Mindest-Klemmenspannung der Batterie unterschritten wird oder nicht. Auch dieses Verfahren stellt hohe Anforderungen an die Sensorik zur Messung der Batteriespannung und erfordert darüber hinaus eine ständige Berechnung des Batterieverhaltens während eines Startvorgangs. Weiterhin ist eine Vorhersage über eine zukünftige Startfähigkeit eines Fahrzeugs nicht möglich.

Es ist daher die Aufgabe der vorliegenden Erfindung, eine Vorrichtung sowie ein Verfahren zur Vorhersage der zukünftigen Startfähigkeit eines Fahrzeugs zu schaffen, bei der bzw. dem keinerlei Messungen von Startströmen oder -spannungen der Fahrzeugbatterie während des Startvorgangs notwendig ist.

Gelöst wird diese Aufgabe gemäß der Erfindung durch die im Patentanspruch 1 sowie im Patentanspruch 11 angegebenen Merkmale. Weitere Ausgestaltungen der Erfindung sind Gegenstand von Unteransprüchen.

Der wesentliche Gedanke der Erfindung besteht darin, die zukünftige Startfähigkeit eines Fahrzeugs nicht auf der Grundlage von gemessenen Startströmen oder -spannungen zu ermitteln, sondern die Startfähigkeit des Fahrzeugs anhand eines Kennlinienfelds (bestehend aus einer oder mehreren Kennlinien) einer elektrischen Batteriegröße, wie z.B. des Startstroms, zu ermitteln. Hierzu ist in der Startfähigkeits-Vorhersagevorrichtung ein Kennfeld hinterlegt, in dem die Abhängigkeit einer elektrischen Batteriegröße, wie z.B. des durch den Starter fließenden Startstroms, von einer zweiten Batteriegröße, wie z.B. vom Ladezustand SOC der Batterie, dargestellt ist. Der bei einem zukünftigen Startvorgang vorliegende Wert der ersten elektrischen Batteriegröße, wie z.B. ein Startstromwert, kann bei Kenntnis der zukünftigen zweiten Batteriegröße, wie z.B.. des zukünftigen Ladezustands (SOCneu), einfach aus dem Kennfeld ausgelesen werden. Der aus dem Kennfeld ausgelesene Wert ist dabei ein Maß für die Startfähigkeit des Fahrzeugs zum zukünftigen Startzeitpunkt. Dieses Verfahren hat den Vorteil, dass keinerlei Startströme oder -spannungen während des Starts gemessen werden müssen, um die Startfähigkeit zu bestimmen.

Das Kennfeld der elektrischen Batteriegröße kann für einen vorgegebenen Batterietyp und ein vorgegebenes Startsystem durch Messungen am Prüfstand ermittelt werden. Das empirisch ermittelte Kennfeld muss anschließend nur im Vorhersagesystem hinterlegt werden, so dass der voraussichtliche Wert der ersten elektrischen Batteriegröße, wie z.B. der zukünftige Batteriestrom oder die Batteriespannung, ermittelt werden kann. Die Einrichtung, in der das Kennfeld hinterlegt ist, gibt in Abhängigkeit von der zweiten Batteriegröße den Wert der ersten elektrischen.Batteriegröße aus, der bei einem zukünftigen Startvorgang vorliegen würde. Die Ausgangsgröße der Einrichtung ist beispielsweise ein Startstrom oder eine Batteriespannung, die sich bei einem zukünftigen Startvorgang einstellen wird. Daraus kann schließlich die Startfähigkeit bestimmt werden.

Gemäß einer bevorzugten Ausführungsform der Erfindung umfaßt die Vorrichtung zur Vorhersage der Startfähigkeit eines Fahrzeugs eine Batteriezustandserkennung zum Ermitteln des Ladezustands (SOC) der Fahrzeugbatterie, eine Einrichtung, die aus dem Entladestromverlauf bei abgestelltem Fahrzeug die während einer vorgegebenen Abstelldauer aus der Fahrzeugbatterie entnommene Ladung (deltaSOC) ermittelt und den verbleibenden Ladezustand (SOCneu) der Fahrzeugbatterie nach der vorgegebenen Abstelldauer berechnet, eine Einrichtung zur Bestimmung einer ersten elektrischen Batteriegröße aus einem hinterlegten Kennfeld, die einen Wert der elektrischen Batteriegröße ausgibt, der sich bei einem zukünftigen Start einstellen würde, und eine Prädiktionseinrichtung, die anhand des ausgegebenen elektrischen Batteriewerts ermittelt, ob das Fahrzeug nach der vorgegebenen Abstelldauer startfähig ist oder nicht.

Das Kennfeld kann entweder in Form einer Funktion oder in Form von Wertepaaren hinterlegt sein. Die Kennlinien des Kennfeldes sind vorzugsweise Strom-, Spannungs- oder Leistungskennlinien z.B. in Abhängigkeit vom Ladezustand der Batterie.

Eine höhere Genauigkeit der Vorhersage kann erzielt werden, wenn die Temperaturabhängigkeit der Batterie und des Startsystems berücksichtigt wird. In diesem Fall ist das Kennfeld außerdem eine Funktion der Temperatur T.

Die bei einem zukünftigen Start vorherrschende Temperatur kann beispielsweise mittels einer Einrichtung zur Temperaturvorhersage bestimmt werden. Da eine genaue Vorhersage der zum Startzeitpunkt vorherrschenden Temperatur nicht möglich ist (bereits die Nachttemperatur kann sich wesentlich von der Tagtemperatur unterscheiden), wird vorzugsweise ein Mittelwert bereits gemessener Temperaturen über einen vorgegebenen Zeitraum bestimmt. Zur Erzeugung eines Mittelwerts kann beispielsweise ein dem Temperatursensor nachgeschaltetes Tiefpassfilter verwendet werden. Der Temperaturmittelwert wird vorzugsweise bei der Bestimmung der ersten elektrischen Batteriegröße berücksichtigt.

In der Prädiktionseinrichtung ist vorzugsweise ein Kennfeld einer mechanischen Größe des Startsystems (das Startsystem umfasst alle angetriebenen Teile bis zum Motor), wie z.B. ein Momentenkennfeld, sowie eine Motormomentenkennlinie hinterlegt. Das Momentenkennfeld des Startsystems wird vorzugsweise ebenfalls in Prüfstandmessungen ermittelt.

Das Momentenkennfeld des Startsystems ist eine Funktion einer elektrischen Batteriegröße, wie z.B. des Ladezustands oder des Innenwiderstands der Batterie. Aus dem Momentenkennfeld wird in Abhängigkeit der ermittelten ersten elektrischen Batteriegröße unter Berücksichtigung wenigstens des Ladezustands SOCneu die zugehörige Momentenkennlinie ermittelt. Die Prädiktionseinrichtung kann somit die Startfähigkeit des Fahrzeugs durch einen Momentenvergleich bestimmen.

Die Vorhersagegenauigkeit kann wiederum verbessert werden, wenn bei der Bestimmung des Startmoments die Temperatur berücksichtigt wird. Die Kennlinien des Momentkennfeldes des Startsystems können daher auch als Funktion der Temperatur hinterlegt sein.

Wahlweise kann das Kennfeld der ersten elektrischen Batteriegröße an den aktuellen Zustand des Startsystems, der durch verschiedene Betriebsgrößen beeinflusst wird, angepasst werden. Das Kennfeld der ersten elektrischen Batteriegröße wird, wie erwähnt, durch Prüfstandmessungen bei definierten Bedingungen, wie z.B. einer definierten Kühlmitteltemperatur, einem definierten Batterie-Innenwiderstand, einem definierten Zustand von Glühkerzen, etc. ermittelt. Eine Änderung dieser Parameter hat Einfluß auf die elektrischen Batteriegrößen wie z.B. den Startstrom, während eines Startvorgangs. Der tatsächlich auftretende Startstrom kann somit z.B. von dem am Prüfstand gemessenen Startstrom abweichen. Das hinterlegte Kennfeld der elektrischen Batteriegröße kann an geänderte Betriebsbedingungen angepaßt werden, indem der Startstrom während eines Startvorgangs gemessen wird und das Kennfeld entsprechend angepaßt wird. Mit Hilfe dieses Adaptionsalgorithmus kann insbesondere die Alterung des Verbrennungsmotors und von Komponenten des Startsystems, sowie ein Batterie- und Ölwechsel berücksichtigt werden.

Gemäß einer bevorzugten Ausführungsform sind in der Vorhersagevorrichtung Kennfelder für unterschiedliche Startsysteme und Motoren hinterlegt. Das Startsystem umfaßt dabei sämtliche Teile des Fahrzeugs, die für eine Vorhersage der Startfähigkeit von Bedeutung sind, wie insbesondere das Getriebe, die Batterie, den Starter, etc.

Die Erfindung wird nachstehend anhand der beigefügten Figuren beispielhaft näher erläutert. Es zeigen:
Fig. 1 eine schematische Darstellung einer Vorrichtung zur Vorhersage der Startfähigkeit eines Fahrzeugs gemäß einer Ausführungsform der Erfindung;
Fig. 2 ein in einer Prädiktionseinrichtung hinterlegtes Momenten-Kennfeld des Startsystems zur Bestimmung der Startfähigkeit des Fahrzeugs; und
Fig. 3 die wesentlichen Verfahrensschritte eines Verfahrens zur Vorhersage der Startfähigkeit eines Fahrzeugs.

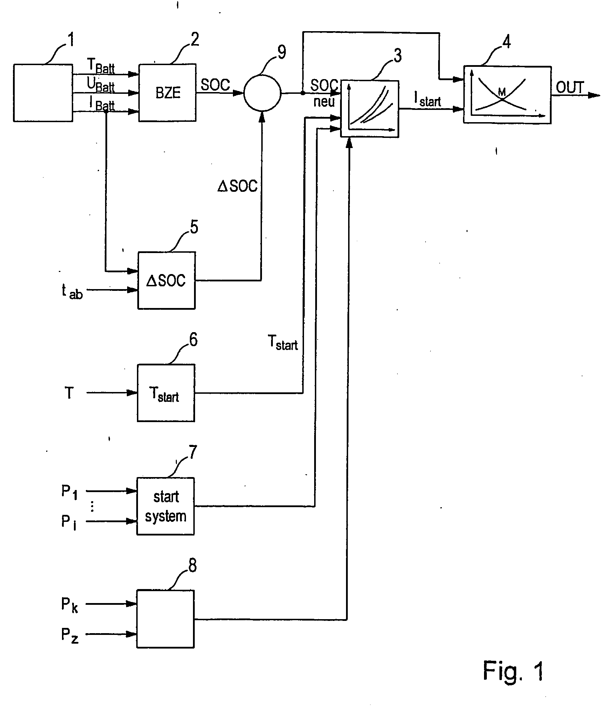

Fig. 1 zeigt eine schematische Darstellung einer Vorrichtung zur Vorhersage der Startfähigkeit eines Fahrzeugs. Die Startfähigkeit des Fahrzeugs wird angenommen, wenn eine Fahrzeugbatterie 1 in der Lage ist, nach einer vorgegebenen Abstelldauer t_{ab} ausreichend elektrische Startenergie zur Verfügung zu stellen, um das Fahrzeug zu starten, ohne eine vorgegebene Mindest-Klemmenspannung zu unterschreiten.

Während der Abstelldauer des Fahrzeugs wird die Fahrzeugbatterie durch verschiedene Ruheverbraucher entleert. Gerade bei schwacher Batterie muss der Fahrer informiert werden, ob das Fahrzeug nach einer vorgegebenen Dauer, z.B. drei Tage, noch startfähig sein wird. Alternativ kann der Fahrer auch darüber informiert werden, wie lange das Fahrzeug noch startfähig sein wird.

Die Vorhersage der Startfähigkeit beruht im wesentlichen darauf, einen zukünftigen Ladezustand SOCneu zu ermitteln, den die Fahrzeugbatterie 1 nach der vorgegebenen Abstelldauer t_{ab} aufweist, und aus dem zukünftigen Ladezustand SOCneu den bei einem Startvorgang im Starter fließenden Startstrom Iₛₜₐᵣₜ aus einem Startstrom-Kennfeld zu ermitteln, das in einer Einrichtung 3 hinterlegt ist. Anhand des ermittelten zukünftigen Startstroms Iₛₜₐᵣₜ lässt sich mittels einer Prädiktionseinrichtung 4 vorhersagen, ob das Fahrzeug startfähig sein wird oder nicht.

Wahlweise kann mit der Startfähigkeits-Vorhersagevorrichtung auch vorhergesagt werden, wie lange das Fahrzeug noch startfähig sein wird. Dies kann z. B. ermittelt werden, indem die Abstelldauer t_{ab} solange erhöht wird, bis das Ergebnis negativ ist.

In der Einrichtung 3 zur Bestimmung eines Startstroms Iₛₜₐᵣₜ ist ein Kennfeld des Startstroms für unterschiedliche Ladezustände SOC der Starterbatterie 1 hinterlegt. Das Startstromkennfeld kann durch Prüfstandmessungen und eine anschließende Interpolation der Meßwerte oder durch Rechnersimulation erhalten werden. Der bei einem zukünftigen Start voraussichtlich fließende Startstrom Iₛₜₐᵣₜ kann bei bekanntem zukünftigen Ladezustand SOCneu der Batterie und gegebenenfalls bei bekannter zukünftiger Starttemperatur einfach aus dem Kennfeld ausgelesen werden. Für die Vorhersage der Startfähigkeit ist daher keine Messung der Batteriespannung oder des Batteriestroms (Startstroms) während eines Startvorgangs notwendig.

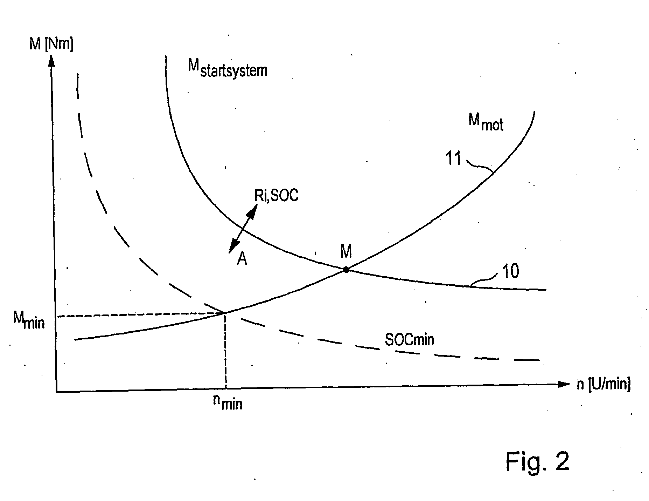

Der so aus dem Kennfeld 3 ermittelte Startstromwert Iₛₜₐᵣₜ bestimmt das vom Startsystem aufgebrachte Startmoment. Zur Vorhersage der Startfähigkeit des Fahrzeugs wird der gegebene Startstromwert Iₛₜₐᵣₜ in einen Momentenwert umgerechnet. In der Prädiktionseinrichtung 4 ist ein Momentenkennfeld des Startsystems M_{startsystem} hinterlegt, wie es in Fig. 2 dargestellt ist. Die dargestellte Momentenkennlinie 10 ist wiederum abhängig vom Ladezustand SOC bzw. vom , Innenwiderstand Ri sowie optional auch von der Temperatur T des Startsystems. Dieses Momentenkennfeld M_{startsystem} wird ebenfalls in Prüfstandmessungen oder Simulationen ermittelt.

Die Prädiktionseinrichtung 4 enthält ferner eine Motormomentenkennlinie 11, die im wesentlichen konstant ist. Am Schnittpunkt der Motormomentenkennlinie 11 mit der Momentenkennlinie 10 des Startsystems (in Abhängigkeit vom zukünftigen Ladezustand SOCneu) ergibt sich das tatsächlich wirkende Startmoment M zum zukünftigen Startzeitpunkt.

Die Startfähigkeit des Fahrzeugs ist gegeben, wenn das derart ermittelte Moment M größer ist als ein erforderliches Mindestmoment Mₘᵢₙ.

Während der Abstelldauer t_{ab} des Fahrzeugs wird durch verschiedene eingeschaltete Ruheverbraucher ständig Strom aus der Batterie entnommen. Zur Berechnung der entnommenen Ladung ist eine Einrichtung 5 vorgesehen, welche beispielsweise durch einfache Integration des Entladestroms die entnommene Ladung berechnet. Der Entladestrom im abgestellten Fahrzeug wird vorzugsweise kurz nach dem Abstellen des Fahrzeugs gemessen. Eine genauere Bestimmung der entnommenen Ladung kann erreicht werden, wenn der Entladestrom zu mehreren Zeitpunkten nach dem Abstellen des Fahrzeugs gemessen wird.

Der aktuelle Ladezustand SOC der Batterie 1 wird von einer aus dem Stand der Technik bekannten Batteriezustandserkennung 2 ermittelt. Die Batteriezustandserkennung 2 erhält hierzu die Batterietemperatur T_{Bat}, die Batteriespannung U_{Bat} und den Batteriestrom I_{Bat} von entsprechenden Sensoren (nicht gezeigt) als Eingangsgrößen.

Der Ladezustand SOCneu der Batterie 1, der sich nach der vorgegebenen Abstelldauer t_{ab} einstellt, wird durch Subtraktion der entnommenen Ladung deltaSOC von der aktuellen Ladung SOC am Subtrahierknoten 9 berechnet. Die Subtrahiereinrichtung 9, ebenso wie andere Einrichtungen des Vorhersagesystems sind vorzugsweise in Software realisiert und laufen z.B. in einem Steuergerät ab.

Die Genauigkeit der Vorhersage kann verbessert werden, wenn die Startstromkennlinien ferner in Abhängigkeit von unterschiedlichen Starttemperaturen hinterlegt sind und die Starttemperatur bei der Vorhersage berücksichtigt wird. Das Vorhersagesystem umfasst hierzu einen Temperatursensor, der die Umgebungstemperatur misst. Die Umgebungstemperatur wird einer Einrichtung 6 zur Vorhersage der Starttemperatur zugeführt, die eine zum Startzeitpunkt voraussichtlich herrschende Starttemperatur abschätzt. Hierzu wird vorzugsweise ein Mittelwert aus mehreren Temperaturwerten, z.B. den Temperaturwerten der letzten Stunden, gebildet. Im einfachsten Fall kann die Mittelwertbildung über einen Tiefpassfilter mit großer Zeitkonstante erfolgen, der eine Mittelwert bildende Funktion hat.

Die Einrichtung 3 zur Bestimmung des Startstroms Iₛₜₐᵣₜ umfasst vorzugsweise Startstromkennlinien für unterschiedliche Startsysteme, d.h. für unterschiedliche Starter-, Motor-, Getriebetypen, etc.. Für die Berechnung des Momentenbedarfs des Startsystems sind insbesondere der Hubraum, die Zylinderzahl, der Motortyp (Diesel/Otto), Verbraucher-Zusatzströme (z.B. durch Glühkerzen), der Getriebetyp (Hand- oder Automatikgetriebe) mit entsprechendem Schleppmoment und der Batterietyp von Bedeutung. Die aktuellen Parameter P1...Pi des Startsystems werden einer Auswähleinheit 7 zugeführt, die die zum Startsystem passende Startstromkennlinie auswählt.

Das Startstromkennfeld ist, wie erwähnt, durch Prüfstandmessungen oder Simulation unter definierten Randbedingungen (Umgebungstemperatur, Batterietyp, Zustand der Glühkerzen etc.) ermittelt worden. Diese Parameter können sich im Laufe des Betriebs ändern. Werden die aktuellen Werte bei der Ermittlung des zukünftigen Startstroms nicht berücksichtigt, so kann der tatsächlich auftretende Startstrom von dem aus der Kennlinie ausgelesenen Startstrom Iₛₜₐᵣₜ abweichen. Das Kennfeld wird daher vorzugsweise an die aktuellen Bedingungen angepaßt.

Hierzu werden z.B. Startstrommessungen durchgeführt und das Startstromkennfeld z.B. durch Verschiebung der Kennlinien entsprechend angepasst. Wahlweise können auch verschiedene Parameter Pk...Pz (Umgebungstemperatur, Batterietyp, Zustand der Glühkerzen etc.), sofern diese bekannt sind, berücksichtigt werden, um die passende Startstromkennlinie auszuwählen. In diesem Fall wären die Startstromkennlinien als Funktion dieser Parameter hinterlegt. Mit Hilfe dieses Adaptionsalgorithmus können insbesondere der Verschleiß im Verbrennungsmotor und Startsystem sowie Batteriealterung und Ölwechsel berücksichtigt werden.

Fig. 2 zeigt die Bestimmung der Startfähigkeit des Fahrzeugs mit Hilfe von Momentenkennlinien.

Zur Bestimmung eines Arbeitspunktes M, der sich bei einem Startvorgang einstellt, sind in der Prädiktionseinrichtung 4 das Motormoment Mₘₒₜₒᵣ über der Drehzahl n, sowie ein Kennfeld des Startsystem-Moments M_{startsystem} hinterlegt. Das Moment des Startsystems M_{startsystem} ist wiederum vom Ladezustand SOC, dem Innenwiderstand Ri der Batterie 1 und der Starttemperatur Tₛₜₐᵣₜ abhängig. Bei geringerem Ladezustand SOC der Batterie verringert sich das vom Startsystem ausgeübte Moment M_{startsystem} in Richtung der gestrichelt dargestellten Linie, die den Momentenverlauf beim niedrigsten Ladezustand SOC darstellt, der für einen erfolgreichen Start notwendig ist.

Das Kennfeld des Startsystem-Moments M_{startsystem} wird wiederum durch Prüfstandmessungen oder Simulation ermittelt.

Die Prädiktionseinrichtung 4 bestimmt aus dem von der Einrichtung 3 gelieferten Startstrom Iₛₜₐᵣₜ unter Berücksichtigung des Ladezustands SOCneu der Batterie 1 sowie gegebenenfalls der Temperatur T und dem Innenwiderstand Ri den Arbeitspunkt M. Das am Motor wirkende Moment M stellt sich dort ein, wo das vom Startsystem ausgeübte Moment M_{startsystem} gleich dem Motormoment Mₘₒₜₒᵣ ist. Ist dieser Arbeitspunkt M größer als ein minimal erforderliches Moment Mₘᵢₙ, so ist die Startfähigkeit des Fahrzeugs nach der vorgegebenen Abstelldauer t_{ab} gegeben.

Um zu bestimmen, wie lange das Fahrzeug insgesamt abgestellt werden kann, ohne die Startfähigkeit zu verlieren, wird die vorgegebene Abstelldauer t_{ab} schrittweise erhöht, bis der Arbeitspunkt M innerhalb der vorgegebenen minimalen Grenzen Mₘᵢₙ, nₘᵢₙ liegt. Der vorhergehende Zeitwert t_{ab} gibt dann ungefähr die maximale Abstelldauer wieder.

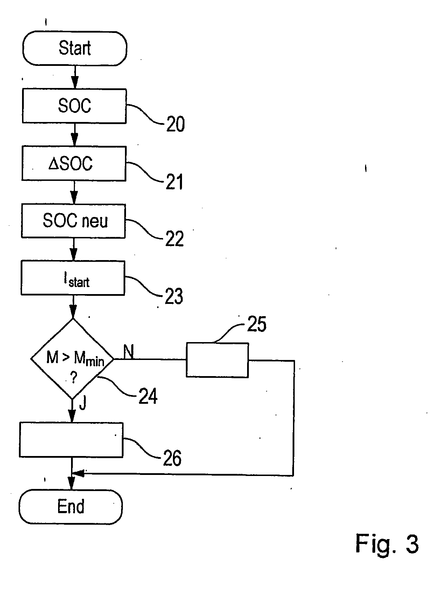

Figur 3 zeigt die wesentlichen Verfahrensschritte eines Verfahrens zur Vorhersage der Startfähigkeit eines Fahrzeugs. Darin wird in einem ersten Schritt 20 der aktuelle Ladezustands SOC der Fahrzeugbatterie 1 mittels einer Batteriezustandserkennung 2 ermittelt. In Schritt 21 wird die Ladung deltaSOC, die während einer vorgegebenen Zeitdauer t_{ab} bei abgestelltem Fahrzeug aus der Fahrzeugbatterie 1 entnommen wird, ermittelt, und in Schritt 22 der Ladezustand SOCneu der Fahrzeugbatterie 1 nach der vorgegebenen Zeitdauer t_{ab} berechnet. In Schritt 23 wird eine elektrische Batteriegröße, z.B. der zukünftige Startstrom Iₛₜₐᵣₜ auf der Grundlage des berechneten zukünftigen Ladezustands SOCneu der Fahrzeugbatterie 1 aus einem in einer Einrichtung 3 hinterlegten Kennfeld ausgelesen. Der ausgelesene Startstromwert Iₛₜₐᵣₜ wird in ein Moment umgerechnet und in Schritt 24 durch Vergleich mit einem minimal erforderlichen Moment Mₘᵢₙ ermittelt, ob das Fahrzeug nach der vorgegebenen Zeitdauer t_{ab} startfähig ist (Fall J) oder nicht (Fall N).
Der Momentenvergleich wird in einer Prädiktionseinrichtung 4 durchgeführt. Das Ergebnis wird in Block 25 bzw. 26 mittels einer geeigneten Anzeigeeinrichtung angezeigt.

### Bezugszeichenliste

- 1: Fahrzeugbatterie
- 2: Batteriezustandserkennung
- 3: Startstromkennfeld
- 4: Prädiktionseinrichtung
- 5: Einrichtung zur Berechnung der entnommenen Ladung
- 6: Einrichtung zur Vorhersage der Starttemperatur
- 7: Einrichtung zur Auswahl des Startsystems
- 8: Einrichtung zur Adaption des Startstrom-Kennfeldes
- 9: Subtrahiereinrichtung
- 10: Startsystem-Moment
- 11: Motormoment
- M: Arbeitspunkt
- T: Temperatur
- SOC: Ladezustand der Batterie 1
- SOCneu: zukünftiger Ladezustand
- t_{ab}: Abstelldauer
- A: Verschiebung
- Mₘᵢₙ: minimales Startmoment
- Nₘᵢₙ: minimale Startdrehzahl

## Patentansprüche

1. Vorrichtung zur Vorhersage der Startfähigkeit eines Fahrzeugs mit einem Verbrennungsmotor und einem Starter, der von einer Fahrzeugbatterie (1) mit elektrischer Energie versorgt wird, **gekennzeichnet durch**
- eine Batteriezustandserkennung (2) zum Ermitteln des Ladezustands (SOC) der Fahrzeugbatterie (1),
- eine Einrichtung (5), die aus einem Entladestromverlauf (I_{Batt,entl}) bei abgestelltem Fahrzeug die in einer vorgegebenen Zeitdauer (t_{ab}) aus der Fahrzeugbatterie (1) entnommene Ladung (deltaSOC) ermittelt,
- eine Einrichtung (9), die den Ladezustand (SOCneu) der Fahrzeugbatterie (1) nach der vorgegebenen Zeitdauer (t_{ab}) berechnet,
- eine Einrichtung (3) zur Bestimmung einer elektrischen Batteriegröße (Iₛₜₐᵣₜ), in der ein Kennfeld der elektrischen Batteriegröße (Iₛₜₐᵣₜ) in Abhängigkeit vom Ladezustand (SOC) der Batterie (1) hinterlegt ist, aus dem ein Wert der elektrischen Batteriegröße (Iₛₜₐᵣₜ) ausgelesen wird, der nach der vorgegebenen Zeitdauer (t_{ab}) vorliegt
- und die elektrische Batteriegröße (Iₛₜₐᵣₜ) der Startstrom ist
- eine Prädiktionseinrichtung (4) die anhand des ausgelesenen elektrischen Batteriewerts (Iₛₜₐᵣₜ) ermittelt, ob das Fahrzeug nach der vorgegebenen Zeitdauer (t_{ab}) startfähig ist oder nicht.

2. Vorrichtung nach Anspruch 1, **dadurch gekennzeichnet, dass** das in der Einrichtung (3) zur Bestimmung einer elektrischen Batteriegröße (Iₛₜₐᵣₜ) hinterlegte Kennfeld ein Strom-, Spannungs- oder Leistungskennfeld ist.

3. Vorrichtung nach Anspruch 1 oder 2, **dadurch gekennzeichnet, dass** das in der Einrichtung (3) zur Bestimmung einer elektrischen Batteriegröße hinterlegte Kennfeld eine Funktion der Temperatur (T) ist.

4. Vorrichtung nach einem der vorhergehenden Ansprüche, **dadurch gekennzeichnet, dass** eine Einrichtung (6) zur Vorhersage der nach der vorgegebenen Zeitdauer (t_{ab}) voraussichtlich herrschenden Temperatur (T) vorgesehen ist, wobei die ermittelte Temperatur (T) bei der Bestimmung der elektrischen Batteriegröße (Iₛₜₐᵣₜ) berücksichtigt wird.

5. Vorrichtung nach einem der vorhergehenden Ansprüche, **dadurch gekennzeichnet, dass** in der Prädiktionseinrichtung (4) ein Kennfeld (10) einer mechanischen Größe einer Starteinrichtung hinterlegt ist.

6. Vorrichtung nach einem der vorhergehenden Ansprüche, **dadurch gekennzeichnet, dass** in der Prädiktionseinrichtung (6) ein Momentenkennfeld (10) des Startsystems und eine Motormomentenkennlinie (11) hinterlegt sind.

7. Vorrichtung nach Anspruch 6, **dadurch gekennzeichnet, dass** das Momentenkennfeld (10) des Startsystems eine Funktion des Ladezustands (SOC) der Fahrzeugbatterie (1) ist.

8. Vorrichtung nach Anspruch 6 oder 7, **dadurch gekennzeichnet, dass** das Momentenkennfeld (10) des Startsystems eine Funktion der Temperatur (T) ist.

9. Vorrichtung nach einem der vorhergehenden Ansprüche, **dadurch gekennzeichnet, dass** eine Einrichtung (6) zum Messen einer elektrischen Größe (I_{Batt}) der Fahrzeugbatterie (1) bei einem Startvorgang vorgesehen ist, mit der das hinterlegte Kennfeld korrigiert werden kann.

10. Vorrichtung nach einem der vorhergehenden Ansprüche, **dadurch gekennzeichnet, dass** in der Einrichtung (3) zur Bestimmung einer elektrischen Batteriegröße (Iₛₜₐᵣₜ) Kennlinien für verschiedene Startsysteme hinterlegt sind.

11. Verfahren zur Vorhersage der Startfähigkeit eines Fahrzeugs mit einem Verbrennungsmotor und einem Starter, der von einer Fahrzeugbatterie (1) mit elektrischer Energie versorgt wird, **gekennzeichnet durch** folgenden Schritte:
- Ermitteln des aktuellen Ladezustands (SOC) der Fahrzeugbatterie (1) mittels einer Batteriezustandserkennung (2),
- Ermitteln der Ladung (deltaSOC), die während einer vorgegebenen Zeitdauer (t_{ab}) bei abgestelltem Fahrzeug aus der Fahrzeugbatterie (1) entnommen wird, abhängig von einem Entladestromverlauf (I_{Batt,entl})
- Berechnen des Ladezustands (SOCneu) der Fahrzeugbatterie (1) nach der vorgegebenen Zeitdauer (t_{ab}),
- Ermitteln einer elektrischen Batteriegröße (Iₛₜₐᵣₜ) auf der Grundlage des berechneten zukünftigen Ladezustands. (SOCneu) der Fahrzeugbatterie (1) aus einem in einer Einrichtung (3) hinterlegten Kennfeld des Startstroms,
- Ermitteln, ob das Fahrzeug nach der vorgegebenen Zeitdauer (t_{ab}) startfähig ist oder nicht, mittels einer Prädiktionseinrichtung (4), die die Startfähigkeit auf der Grundlage der aus dem Kennfeld ermittelten Batteriegröße (Iₛₜₐᵣₜ) bestimmt.

12. Verfahren nach Anspruch 11, **dadurch gekennzeichnet, dass** in der Einrichtung (3) zur Bestimmung einer elektrischen Batteriegröße ein Kennfeld für einen Startstrom in Abhängigkeit vom Ladezustand (SOC) der Fahrzeugbatterie (1) hinterlegt ist, aus dem ein Startstrom (Iₛₜₐᵣₜ) ermittelt wird, der sich nach der vorgegebenen Zeitdauer (t_{ab}) einstellt.

13. Verfahren nach Anspruch 11 oder 12, **dadurch gekennzeichnet, dass** die Prädiktionseinrichtung (4) einen Momentenvergleich zwischen einem Motormoment (Mₘₒₜₒᵣ) und einem Moment (M_{startsystem}) eines Startsystems durchführt, um ein zukünftig wirkendes Moment (M) zu bestimmen.

## Claims

1. Apparatus for prediction of the starting capability of a vehicle having an internal combustion engine and having a starter which is supplied with electrical power from a vehicle battery (1), **characterized by**
- a battery status identification (2) for determination of the state of charge (SOC) of the vehicle battery (1),
- a device (5) which uses a discharge current profile (I_{Batt,dis}) when the vehicle is parked to determine the charge (deltaSOC) taken from the vehicle battery (1) in a predetermined time period (t_{ab})
- a device (9) which calculates the state of charge (SOCnew) of the vehicle battery (1) after the predetermined time period (t_{ab}),
- a device (3) for determination of an electrical battery variable (Iₛₜₐᵣₜ), in which a family of characteristics of the electrical battery variable (Iₛₜₐᵣₜ) is stored as a function of the state of charge (SOC) of the battery (1), from which a value of the electrical battery variable (Iₛₜₐᵣₜ) is read, which value is that present after the predetermined time period (t_{ab}),
- and the electrical battery variable (SOC) is the starting current,
- a prediction device (4) which uses the electrical battery value (Iₛₜₐᵣₜ) that has been read to determine whether the vehicle can or cannot be started after the predetermined time period (t_{ab}).

2. Apparatus according to Claim 1, **characterized in that** the family of characteristics which is stored in the device (3) in order to determine an electrical battery variable (Iₛₜₐᵣₜ) is a current, voltage or power family of characteristics.

3. Apparatus according to Claim 1 or 2, **characterized in that** the family of characteristics which is stored in the device (3) in order to determine an electrical battery variable is a function of the temperature (T).

4. Apparatus according to one of the preceding claims, **characterized in that** a device (6) is provided for prediction of the temperature (T) which is predicted will be present after the predetermined time period (t_{ab}) with the determined temperature (T) being taken into account within the determination of the electrical battery variable (Iₛₜₐᵣₜ).

5. Apparatus according to one of the preceding claims, **characterized in that** a family of characteristics (10) of a mechanical variable of a starting device is stored in the prediction device (4).

6. Apparatus according to one of the preceding claims, **characterized in that** a torque family of characteristics (10) for the starting system and an engine torque characteristic (11) are stored in the prediction device (6).

7. Apparatus according to Claim 6, **characterized in that** the torque family of characteristics (10) of the starting system is a function of the state of charge (SOC) of the vehicle battery (1).

8. Apparatus according to Claim 6 or 7, **characterized in that** the torque family of characteristics (10) of the starting system is a function of the temperature (T).

9. Apparatus according to one of the preceding claims, **characterized in that** a device (6) is provided for measurement of an electrical variable (I_{Batt}) of the vehicle battery (1) during a starting process, by means of which the stored family of characteristics can be corrected.

10. Apparatus according to one of the preceding claims, **characterized in that** characteristics for different starting systems are stored in the device (3) for determination of an electrical battery variable (Iₛₜₐᵣₜ).

11. Method for prediction of the starting capability of a vehicle having an internal combustion engine and a starter, which is supplied with electrical power from a vehicle battery (1), **characterized by** the following steps:
- the instantaneous state of charge (SOC) of the vehicle battery (1) is determined by means of a battery status identification (2),
- the charge (deltaSOC) which is taken from the vehicle battery (1) during a predetermined time period (t_{ab}) in which the vehicle is parked is determined as a function of a discharge current profile (I_{Batt,dis}),
- the state of charge (SOCnew) of the vehicle battery (1) is calculated after the predetermined time period (t_{ab}),
- an electrical battery variable (Iₛₜₐᵣₜ) is determined on the basis of the calculated future state of charge (SOCnew) of the vehicle battery (1) from a family of characteristics of the starting current, which is stored in a device (3),
- determination of whether the vehicle can or cannot be started after the predetermined time period (t_{ab}), by means of a prediction device (4) which determines the starting capability on the basis of the battery variable (Iₛₜₐᵣₜ) determined from the family of characteristics.

12. Method according to Claim 11, **characterized in that** a family of characteristics for a starting current is stored as a function of the state of charge (SOC) of the vehicle battery (1) in the device (3) for determination of an electrical battery variable, from which a starting current (Iₛₜₐᵣₜ) is determined which will occur after the predetermined time period (t_{ab}).

13. Method according to Claim 11 or 12, **characterized in that** the prediction device (4) carries out a torque comparison between an engine torque (M_{engine}) and a torque (M_{startsystem}) of a starting system, in order to determine a torque (M) which will act in the future.

## Revendications

1. Dispositif pour prévoir la capacité de démarrage d'un véhicule équipé d'un moteur à combustion interne et d'un démarreur alimenté en énergie électrique à partir d'une batterie (1) du véhicule,
**caractérisé par**
- une caractéristique d'état de batterie (2) pour déterminer l'état de charge (SOC) de la batterie (1) du véhicule,
- une installation (5) qui, à partir d'une courbe de courant de décharge (I_{batt,ent1}) lorsque le véhicule est arrêté, détermine la charge prélevée (deltaSOC) au cours d'une durée prédéfinie (t_{ab}) dans la batterie (1) du véhicule,
- une installation (9) qui calcule l'état de charge (SOCneu) de la batterie (1) du véhicule après une durée prédéfinie (t_{ab}),
- une installation (3) pour déterminer une grandeur électrique de la batterie (Iₛₜₐᵣₜ) dans un champ de caractéristiques de grandeurs électriques de batterie (Iₛₜₐᵣₜ) en fonction de l'état de charge (SOC) de la batterie (1), d'où l'on extrait une valeur de la grandeur électrique de la batterie (Iₛₜₐᵣₜ) disponible après une durée prédéfinie (t_{ab}),
- et la grandeur électrique de la batterie (Iₛₜₐᵣₜ) est le courant de démarrage,
- une installation de prédiction (4) qui détermine, à partir de la grandeur électrique lue de la batterie (Iₛₜₐᵣₜ), si le véhicule est susceptible ou non de démarrer après la durée prédéfinie (t_{ab}).

2. Dispositif selon la revendication 1,
**caractérisé en ce que**
le champ de caractéristiques enregistré dans l'installation (3) pour déterminer une grandeur électrique de batterie (Iₛₜₐᵣₜ) est un champ de caractéristiques intensité-tension ou un champ de caractéristiques de puissance.

3. Dispositif selon la revendication 1 ou 2,
**caractérisé en ce que**
le champ de caractéristiques enregistré dans l'installation (3) pour déterminer une grandeur électrique de la batterie (Iₛₜₐᵣₜ) est une fonction de la température (T).

4. Dispositif selon l'une des revendications précédentes,
**caractérisé par**
une installation (6) pour prévoir la température (T) régnant de façon prévisionnelle après une durée prédéfinie (t_{ab}) et cette température (T) obtenue est prise en compte pour déterminer la grandeur électrique de la batterie (Iₛₜₐᵣₜ).

5. Dispositif selon l'une des revendications précédentes,
**caractérisé en ce qu'**
un champ de caractéristiques (10) d'une grandeur mécanique d'une installation de démarrage est enregistré dans l'installation de prévision (4).

6. Dispositif selon l'une quelconque des revendications précédentes,
**caractérisé en ce qu'**
un champ de couple (10) du système de démarrage et une courbe caractéristique de couple moteur (11) sont enregistrés dans l'installation de prévision (6).

7. Dispositif selon la revendication 6,
**caractérisé en ce que**
le champ de couple (10) du système de démarrage est une fonction de l'état de charge (SOC) de la batterie (1) du véhicule.

8. Dispositif selon la revendication 6 ou 7,
**caractérisé en ce que**
le champ de caractéristiques de couple (10) du système de démarrage est une fonction de la température (T).

9. Dispositif selon l'une des revendications précédentes,
**caractérisé par**
une installation (6) pour mesurer une grandeur électrique (I_{Batt}) de la batterie du véhicule (1) pour une opération de démarrage à l'aide de laquelle on peut corriger le champ de caractéristiques enregistré.

10. Dispositif selon l'une des revendications précédentes,
**caractérisé en ce que**
les courbes caractéristiques de différents systèmes de démarrage sont enregistrées dans l'installation (3) pour déterminer une grandeur électrique de batterie (Iₛₜₐᵣₜ).

11. Procédé de prévision de la capacité de démarrage d'un véhicule équipé d'un moteur à combustion interne et d'un démarreur alimenté en énergie électrique à partir de la batterie (1) du véhicule,
**caractérisé par** les étapes suivantes :
- détermination de l'état de charge actuel (SOC) de la batterie (1) du véhicule à l'aide d'une détection d'état de batterie (2),
- détermination de la charge (deltaSOC) prélevée pendant une durée prédéfinie (t_{ab}) lorsque le véhicule est arrêté, à partir de la batterie (1) du véhicule et en fonction d'une courbe de courant de décharge (I_{Batt,entl}),
- calcul de l'état de charge (SOCneu) de la batterie (1) du véhicule après la durée prédéfinie (t_{ab}),
- détermination d'une grandeur électrique de batterie (Iₛₜₐᵣₜ) sur la base de l'état de charge, futur, calculé (SOCneu) de la batterie (1) du véhicule à partir d'un champ de caractéristiques du courant de démarrage enregistré, dans une installation (3),
- détermination si après la durée prédéfinie (t_{ab}), le véhicule est susceptible de démarrer ou non, à l'aide d'une installation de prévision (4) qui définit la capacité de démarrage sur le fondement de la grandeur de la batterie (Iₛₜₐᵣₜ) déterminée dans le champ de caractéristiques.

12. Procédé selon la revendication 11,
**caractérisé en ce qu'**
un champ de caractéristiques pour un courant de démarrage en fonction de l'état de charge (SOC) de la batterie (1) du véhicule est enregistré dans l'installation (3) pour déterminer une grandeur électrique de batterie, champ à partir duquel on détermine le courant de démarrage (Iₛₜₐᵣₜ), qui s'établit après une durée prédéfinie (t_{ab}).

13. Procédé selon la revendication 11 ou 12,
**caractérisé en ce que**
l'installation prévisionnelle (4) effectue une comparaison de couple entre le couple moteur (Mₘₒₜ) et un couple (M_{startsystem}) d'un système de démarrage pour déterminer le couple agissant à l'avenir (M).
